# EUROPÄISCHE PATENTSCHRIFT

(11) **EP 2 634 921 B1**
(45) Veröffentlichungstag und Bekanntmachung des Hinweises auf die Patenterteilung: **04.12.2019**
(21) Anmeldenummer: 13156002.1
(22) Anmeldetag: 20.02.2013
(51) Int. Cl.: H03K 17/95, G01S 13/02, G01V 3/10, F41G 9/00

(54) **Annäherungssensor und Verfahren zum Bestimmen der Annäherung an einen elektrisch leitfähigen Körper**
Proximity sensor and method for determining the approach to electrically conductive body
Capteur de rapprochement et procédé de détermination du rapprochement sur un corps conducteur électrique

(30) Priorität: 01.03.2012 DE 102012004308
(43) Veröffentlichungstag der Anmeldung: 04.09.2013
(73) Patentinhaber: ATLAS ELEKTRONIK GmbH, 28309 Bremen (DE)
(72) Erfinder: Knaak, Heinz, 25436 Uetersen (DE)
(74) Vertreter: thyssenkrupp Intellectual Property GmbH

(56) Entgegenhaltungen:
- EP-A1- 0 523 563
- EP-A1- 1 826 586
- US-A- 5 361 072

## Beschreibung

Die Erfindung betrifft einen Annäherungssensor zur Bestimmung der Annäherung an einen elektrisch leitfähigen Körper nach Anspruch 1 und ein Verfahren zum Bestimmen der Annäherung an einen elektrisch leitfähigen Körper nach Anspruch 9.

Herkömmlicherweise werden Annäherungssensoren zur Annäherungsbestimmung an einen elektrisch leitfähigen Körper genutzt, die eine Sendeanordnung mit einem Schwingkreis aufweisen. Mit dem Schwingkreis wird eine elektrische Schwingung mit einer vordefinierten ausgewählten Frequenz erzeugt. Die elektrische Schwingung wiederum erzeugt ein Wechselmagnetfeld, das von einer Spule des Schwingkreises ausgesendet wird und dieselbe Frequenz wie die elektrische Schwingung aufweist. Das ausgesendete Wechselmagnetfeld breitet sich vom Annäherungssensor aus und trifft im Falle, dass sich im Bereich des ausgesendeten Wechselmagnetfeldes ein elektrisch leitfähiger Körper befindet, auf diesen. Im elektrisch leitfähigen Körper wird durch das ausgesendete Wechselmagnetfeld ein Wechselstrom, der auch Wirbelstrom genannt wird, erzeugt. Dieser Wirbelstrom führt zu einem Wechselmagnetfeld, das dieselbe Frequenz wie das ausgesendete Wechselmagnetfeld aufweist.

Ferner weisen derartige Annäherungssensoren eine Empfangsanordnung auf, mit der ein Wechselmagnetfeld erfasst wird. Mit dieser Empfangsanordnung wird insbesondere das Wechselmagnetfeld, das vom elektrisch leitfähigen Körper aus zurückgesendet wird, erfasst. Durch Vergleich des ausgesendeten und des erfassten Wechselmagnetfeldes, z.B. durch Vergleich deren maximalen Amplituden und/oder deren Phasenverschiebung, kann dann die Annäherung bzw. ein Grad der Annäherung des elektrisch leitfähigen Körpers an den Annäherungssensor bestimmt werden.

Bei dieser Bestimmung der Annäherung treten jedoch dann falsche Werte auf, wenn störende Wechselmagnetfelder, insbesondere mit der gleichen Frequenz wie der jeweiligen ausgesendeten Frequenz des ausgesendeten Wechselmagnetfeldes, im Bereich der Empfangsanordnung auftreten. Diese können z.B. durch in der Umgebung vorhandene Elektromotoren oder andere Störer entstehen.

US 5,361,072 A offenbart ein Niederfrequenzradargerät für eine Weitwinkelüberwachung.

Der Erfindung liegt die Aufgabe zugrunde, einen Annäherungssensor und ein Verfahren zum Bestimmen der Annäherung an einen elektrisch leitfähigen Körper zu finden, die unabhängig von störenden Wechselmagnetfeldern eine zuverlässige Bestimmung der Annäherung ermöglichen.

Die Erfindung löst diese Aufgabe durch einen Annäherungssensor zur Bestimmung der Annäherung an einen elektrisch leitfähigen Körper gemäß Anspruch 1 und ein Verfahren zum Bestimmen der Annäherung an einen elektrisch leitfähigen Körper gemäß Anspruch 9.

Der erfindungsgemäße Annäherungssensor zur Bestimmung der Annäherung weist dazu eine Sendeanordnung auf, mit der ein Wechselmagnetfeld ausgesendet wird. Das Wechselmagnetfeld weist dabei eine Frequenz auf, die einer ausgewählten Frequenz entspricht. Es wird - zeitlich betrachtet - jeweils für ein vorbestimmtes bzw. vordefiniertes Zeitfenster die Frequenz ausgesendet, die zu den Zeitpunkten des aktuellen Zeitfensters der ausgewählten aktuellen Frequenz entspricht.

Ein Wechselmagnetfeld entspricht einem Magnetfeld, dessen Feldstärke sich zeitlich mit einer vordefinierten Frequenz verändert. Hierbei ist eine sich verändernde Feldstärke möglich, die zwischen negativen und positiven Maxima variiert, deren Feldlinien also periodisch in zueinander entgegengesetzten Richtungen verlaufen. Ferner ist eine sich verändernde Feldstärke möglich, die zwischen positiven Minima und Maxima oder negativen Minima und Maxima variiert. Ferner weist die Erfindung eine Empfangsanordnung zum Erfassen eines Wechselmagnetfeldes auf. Diese Empfangsanordnung ist z.B. ein Schwingkreis, dessen durch das erfasste Wechselmagnetfeld erzeugte elektrische Schwingung gemessen wird.

Erfindungsgemäß weist der Annäherungssensor ein Detektionsmittel auf, mit dem eine oder mehrere Frequenzen des erfassten Wechselmagnetfeldes dann aufgefasst bzw. detektiert werden, wenn diese außerhalb eines vordefinierten Frequenzbandes, das die ausgewählte Frequenz aufweist, liegen und einen Amplitudenwert oberhalb eines vordefinierten Schwellenwerts aufweisen.

Mit einem Detektionsmittel werden also zunächst einzelne Frequenzen, die im erfassten Wechselmagnetfeld auftreten, betrachtet. Hierfür wird z.B. ein elektrisches Signal aus dem Wechselmagnetfeld erzeugt, verstärkt und/oder gemischt und in den Spektralbereich, z.B. mit einer Fourier-Transformation, transformiert. Es werden dann alle Frequenzlinien im Spektralbereich detektiert, die nicht der Frequenzlinie der ausgesendeten ausgewählten Frequenz entsprechen oder die nicht in einem vordefinierten Bereich, also einem vordefinierten Frequenzband, um die Frequenzlinie der ausgesendeten ausgewählten Frequenz liegen und die jeweils zusätzlich eine Amplitude aufweisen, die oberhalb eines vordefinierten Schwellenwerts liegt. Diese detektierten Frequenzen werden dann an eine Sperrschaltung einer Steuerlogik übergeben.

Mit der Sperrschaltung werden dann im Falle einer detektierten Frequenz die Frequenzen als gesperrte Frequenzen definiert, die in einem die detektierte Frequenz aufweisenden vordefinierten Frequenzband liegen. "Vordefiniertes Frequenzband" bedeutet ein z.B. in der Bandbreite und/oder bzgl. der Mittenfrequenz - bezogen auf die jeweilige detektierte Frequenz - festgelegtes Frequenzband. Im Falle mehrerer detektierter Frequenzen, werden die Frequenzen als gesperrte Frequenzen definiert, die jeweils in einem von mehreren jeweils mindestens eine der detektierten Frequenzen aufweisenden vordefinierten Frequenzbändern liegen. Diese gesperrten Frequenzen werden von der Sperrschaltung für eine vordefinierte Zeitdauer als gesperrte Frequenzen definiert.

Ferner weist die Steuerlogik eine Auswahlsteuerung auf. Die Auswahlsteuerung dient dem während der Annäherungsbestimmung fortlaufend wiederholten Festlegen jeweils einer auf die jeweilige aktuell ausgewählte Frequenz folgenden Frequenz. Diese auf die jeweilige aktuell ausgewählte Frequenz folgende Frequenz wird als Folgefrequenz der aktuell ausgewählten Frequenz bezeichnet. Eine Folgefrequenz wird dabei derart festgelegt, dass diese sich von der ausgewählten Frequenz, auf die die Folgefrequenz folgt unterscheidet. Ferner wird die Folgefrequenz derart gewählt bzw. festgelegt, dass sich diese von den zurzeit gesperrten Frequenzen unterscheidet. Bei der Festlegung der Folgefrequenz einer aktuell ausgewählten Frequenz werden also die jeweilige aktuelle ausgewählte Frequenz sowie die gesperrten Frequenzen ausgenommen.

In einer Zeitsteuerung wird fortlaufenden eine Folgefrequenz der aktuell ausgewählten Frequenz als neue ausgewählte Frequenz ausgewählt, sodass in aufeinanderfolgenden Zeitfenstern immer unterschiedliche Frequenzen ausgewählt sind, die nicht einer der gesperrten Frequenzen entsprechen. Die Folgefrequenz wird also für ein auf das aktuelle Zeitfenster folgendes Zeitfenster ausgewählt, das zeitlich direkt oder zeitlich beabstandet auf das aktuelle Zeitfenster folgt.

Ferner weist die Erfindung ein Verfahren zum Bestimmen der Annäherung an einen elektrisch leitfähigen Körper auf. Beim Verfahren wird in einem Sendeschritt ein Wechselmagnetfeld mit einer ausgewählten Frequenz ausgesendet und in einem Empfangsschritt ein Wechselmagnetfeld erfasst. In einem Detektionsschritt wird eine oder werden mehrere Frequenzen des erfassten Wechselmagnetfeldes detektiert, die außerhalb eines die ausgewählte Frequenz aufweisenden vordefinierten Frequenzbandes liegen und einen Amplitudenwert oberhalb eines vordefinierten Schwellenwerts aufweisen.

Die im Detektionsschritt detektierten Frequenzen werden in einem Sperrschritt eines Steuerschritts weiterverarbeitet. Im Sperrschritt werden Frequenzen eines die detektierte Frequenz aufweisenden vordefinierten Frequenzbandes oder mehrerer jeweils mindestens eine der detektierten Frequenzen aufweisender vordefinierter Frequenzbänder für eine vordefinierte Zeitdauer als gesperrte Frequenz definiert. In einem Auswahlschritt des Steuerschritts wird fortlaufend eine auf die aktuell ausgewählte Frequenz folgende, sich von der aktuell ausgewählten Frequenz unterscheidende Frequenz ausgewählt, die als Folgefrequenz der jeweiligen aktuell ausgewählten Frequenz bezeichnet wird. Bei der Auswahl bzw. der Festlegung der Folgefrequenz werden die gesperrten Frequenzen ausgenommen.

In einem Zeitsteuerschritt des Steuerschritts wird fortlaufend, also mit dem Fortschreiten der Zeit wiederholt, die Folgefrequenz einer aktuell ausgewählten Frequenz als neue ausgewählte Frequenz festgelegt bzw. ausgewählt. Diese Folgefrequenz wird für ein auf das aktuelle Zeitfenster zeitlich direkt oder zeitlich beabstandet folgendes neues Zeitfenster als ausgewählte Frequenz ausgewählt.

Dank der Erfindung ist eine Bestimmung der Annäherung an einen elektrisch leitfähigen Körper möglich, auch wenn störende Wechselmagnetfelder von der Empfangsanordnung erfasst werden. Dies ist möglich, da sich die ausgewählte Frequenz durch die mit dem Detektionsmittel detektierten und mit der Sperrschaltung gesperrten Frequenzen immer von den Frequenzen störender Wechselmagnetfelder unterscheidet.

Gemäß einer Ausführungsform des Annäherungssensors weist die Sendeanordnung einen Schwingkreis mit mindestens einer Spule und mehreren jeweils durch Schalter in beliebiger Kombination zueinander parallel schaltbaren Kondensatoren auf. Der Schwingkreis dient zum Erzeugen einer elektrischen Schwingung mit der ausgewählten Frequenz und eines aus der Schwingung resultierenden Wechselmagnetfeldes mit derselben Frequenz. Ferner weist die Steuerlogik Ansteuermittel zum Ansteuern der Schalter auf. Durch das Ansteuern der Schalter wird die Gesamtkapazität des Schwingkreises variiert und damit die Frequenz der elektrischen Schwingung umgeschaltet.

Gemäß einer Ausführungsform des Verfahrens werden im Sendeschritt mit einem Schwingkreis eine elektrische Schwingung mit der ausgewählten Frequenz und ein aus der elektrischen Schwingung resultierendes Wechselmagnetfeld mit derselben Frequenz erzeugt. Durch Schalten von Schaltern des Schwingkreises in einen Ansteuerschritt des Steuerschritts wird die Frequenz der elektrischen Schwingung umgeschaltet.

Gemäß einer weiteren Ausführungsform weist der Schwingkreis eine gesteuerte Spannungs- oder Stromquelle, z.B. einen geschalteten Gleichspannungsschaltkreis, auf, um die Schwingung im Schwingkreis anzuregen, aufrecht zu erhalten und die Amplitude der Schwingung, z.B. durch Konstanthalten der Amplitude, zu kontrollieren.

Ein derartiger Schwingkreis ermöglicht die Erzeugung einer elektrischen Schwingung mit einer in Zeitfenstern jeweils weitestgehend konstanten Frequenz die zusätzlich noch durch Schalten der Schalter variierbar ist.

Nach einer weiteren Ausführungsform weist die Sendeanordnung mindestens einen Sensor zum Messen bzw. Erfassen der Energieverteilung innerhalb des Schwingkreises auf. Dazu werden z.B. die magnetische Feldstärke des durch die Spule erzeugten Magnetfeldes und/oder die Spannung über den Kondensatoren gemessen bzw. erfasst. Ferner sind die Ansteuermittel derart ausgebildet, um die Schalter nur im Maximum oder im Bereich des Maximums einer in der Spule gemessenen Energie umzustellen.

Gemäß einer Ausführungsform des Verfahrens wird im Sendeschritt die Energieverteilung innerhalb des Schwingkreises mit dem Sensor gemessen und werden im Ansteuerschritt die Schalter abhängig von der Energieverteilung im Schwingkreis umgeschaltet.

Dank einem Schalten der Schalter nur im Falle, dass die gesamte bzw. weitestgehend die gesamte Energie in der Spule vorliegt, ist es möglich, die Schalter lastfrei zu schalten. Dadurch werden Energieverluste sowie Phasensprünge der elektrischen Schwingung und des daraus resultierenden Wechselmagnetfeldes vermieden. Insgesamt ist somit ein geringerer Energieaufwand erforderlich, um die Schwingung im Schwingkreis trotz Variieren der Frequenz der Schwingung aufrechtzuerhalten.

Gemäß einer weiteren Ausführungsform weist der Annäherungssensor eine Auswerteschaltung mit einer Amplitudenüberwachungsschaltung zum Überwachen der Amplitude der ausgewählten Frequenz, einer aus der ausgewählten Frequenz abgeleiteten Frequenz, der Einhüllenden der ausgewählten Frequenz oder der Einhüllenden der aus der ausgewählten Frequenz abgeleiteten Frequenz des erfassten Wechselmagnetfeldes auf. In einem Auswerteschritt des Annäherungssensors wird in einem Amplitudenüberwachungsschritt des Auswerteschritts die Amplitude der ausgewählten Frequenz, einer aus der ausgewählten Frequenz abgeleiteten Frequenz, der Einhüllenden der ausgewählten Frequenz oder der Einhüllenden der aus der ausgewählten Frequenz abgeleiteten Frequenz des erfassten Wechselmagnetfeldes überwacht.

Mit der Amplitudenüberwachungsschaltung wird z.B. durch Vergleich der Amplitudenwerte bzw. der Werte der überwachten Amplitude, z.B. der Einhüllenden der ausgewählten Frequenz des erfassten Wechselmagnetfeldes, mit in einer ausgewählten Tabelle gespeicherten Werten - unter Beachtung der Amplitude der ausgewählten Frequenz des ausgesendeten Wechselfeldes - der Grad der Annäherung an einen elektrisch leitfähigen Körper bestimmt. Derartige Tabellen werden hierbei z.B. nach der geometrischen Wegstrecke der Annäherungsbewegung des Annäherungssensors an den elektrisch leitfähigen Körper und/oder nach der Form und der Größe sowie des Materials des elektrisch leitfähigen Körpers vorherbestimmt und dann bei der Bestimmung der Annäherung gezielt ausgewählt. Alternativ oder zusätzlich wird durch Vorbeiführen des Annäherungssensors am elektrisch leitfähigen Körper im Maximum oder im Bereich des Maximums der überwachten Amplitude, z.B. der Einhüllenden der ausgewählten Frequenz des erfassten Wechselmagnetfeldes, der kürzeste Abstand zum elektrisch leitfähigen Körper bestimmt bzw. erfasst oder detektiert.

Gemäß einer weiteren Ausführungsform weist die Auswerteschaltung eine Phasenüberwachungsschaltung auf bzw. es wird im Auswerteschritt mit einem Phasenüberwachungsschritt eine Phase überwacht. Genauer gesagt, wird mit der Phasenüberwachungsschaltung bzw. dem Phasenüberwachungsschritt die Phase der ausgewählten Frequenz, einer aus der ausgewählten Frequenz abgeleiteten Frequenz, der Einhüllenden der ausgewählten Frequenz oder der Einhüllenden der aus der ausgewählten Frequenz abgeleiteten Frequenz des erfassten Wechselmagnetfeldes überwacht. Phasenänderungen der überwachten Phasen werden dann erkannt, wenn sich die überwachte Phase zeitlich gesehen schneller ändert als durch einen zweiten Schwellenwert vorgegeben. Im Falle einer derartigen "schnelleren" Phasenänderung bzw. eines Phasensprungs werden die bei der Annäherungsbestimmung erfassten Werte, also der bestimmte Grad der Annäherung, verworfen und als ungültig gekennzeichnet.

Durch die Phasenüberwachungsschaltung ist ein Erkennen störender Wechselmagnetfelder, die trotz des Detektionsmittels "plötzlich" im Frequenzbereich der ausgewählten Frequenz auftreten, möglich, da derartige plötzlich auftretende Wechselmagnetfelder i.d.R. eine andere Phase aufweisen als das ausgesendete Wechselmagnetfeld.

Gemäß einer weiteren Ausführungsform weist die Auswerteschaltung einen Frequenzmischer bzw. der Auswerteschritt einen Frequenzmischerschritt auf. Mit dem Frequenzmischer bzw. in dem Frequenzmischerschritt werden aus dem erfassten sowie dem ausgesendeten Wechselmagnetfeld erzeugte elektrische Signale multiplikativ gemischt, bevor sie z.B. der Phasenüberwachungsschaltung und/oder der Amplitudenüberwachungsschaltung zugeführt werden.

Dank dieser Mischung ist es möglich, das gemischte Signal in der Auswerteschaltung bzw. im Auswerteschritt mit einmalig jeweils für eine Phasenüberwachenschaltung und eine Amplitudenüberwachungsschaltung vordefinierten Bandpässen zu filtern. Ein Verschieben der Bandpässe im Frequenzbereich aufgrund sich ändernder ausgewählter Frequenzen ist somit nicht nötig.

Gemäß einer weiteren Ausführungsform weist der Annäherungssensor eine Speicherschaltung und eine Prädiktionsschaltung auf. Mit der Speicherschaltung wird der zeitliche Verlauf der detektierten Frequenzen gespeichert. Mit der Prädiktionsschaltung werden dann aus diesem zeitlichen Verlauf zukünftig wahrscheinlich auftretende störende Frequenzen prädiziert. Diese prädizierten Frequenzen werden dann der Sperrschaltung der Steuerlogik als weitere detektierte Frequenzen zugeführt. Entsprechend wird in einer Ausführungsform des Verfahrens in einem Speicherschritt der zeitliche Verlauf detektierter Frequenzen gespeichert und in einem Prädiktionsschritt Frequenzen vorherbestimmt, die dann dem Sperrschritt als weitere detektierte Frequenzen zugeführt werden.

Dank der Speicher- und der Prädiktionsschaltung bzw. des Speicher- und des Prädiktionsschritts ist es möglich, bei sich zeitlich bzgl. der Frequenz verändernden störenden Wechselmagnetfeldern bereits im Voraus zukünftige störende Frequenzen störender Wechselmagnetfelder zu prognostizieren und ein Aussenden eines Wechselmagnetfeldes mit diesen Frequenzen zu vermeiden.

Gemäß einer weiteren Ausführungsform weist der Annäherungssensor eine Korrekturschaltung auf, mit der bei der Auswertung der Annäherung bestimmte Werte mit Kenntnis der detektierten Frequenzen korrigiert werden. Durch die Korrekturschaltung ist z.B. in der Auswerteschaltung eine Korrektur der Werte der Amplitude oder Phase möglich, wenn diese durch detektierte Frequenzen beeinflusst sind.

Weitere vorteilhafte Ausführungsformen ergeben sich aus den Unteransprüchen sowie aus den anhand der Zeichnungen näher erläuterten Ausführungsbeispielen. Es zeigen:
- Fig. 1: ein Wasserfahrzeug mit einem Ausführungsbeispiel des erfindungsgemäßen Annäherungssensors,
- Fig. 2: einen Schwingkreis einer Sendeanordnung,
- Fig. 3: ein exemplarisch dargestellter, in einer Steuerlogik eines Annäherungssensors stattfindender zeitlicher Ablauf,
- Fig. 4: einen Ausschnitt des zeitlichen Verlaufs der Amplitude einer elektrischen Schwingung in einem Ausführungsbeispiel eines Schwingkreises einer erfindungsgemäßen Sendeanordnung,
- Fig. 5: einen schematischen Aufbau eines Ausführungsbeispiels des erfindungsgemäßen Annäherungssensors,
- Fig. 6: ein Ausführungsbeispiel einer Auswerteschaltung,
- Fig. 7: einen Ablaufplan eines Ausführungsbeispiels des erfindungsgemäßen Verfahrens und
- Fig. 8: den zeitlichen Verlauf der Frequenz eines ausgesendeten Wechselmagnetfeldes sowie eines störenden Wechselmagnetfeldes.

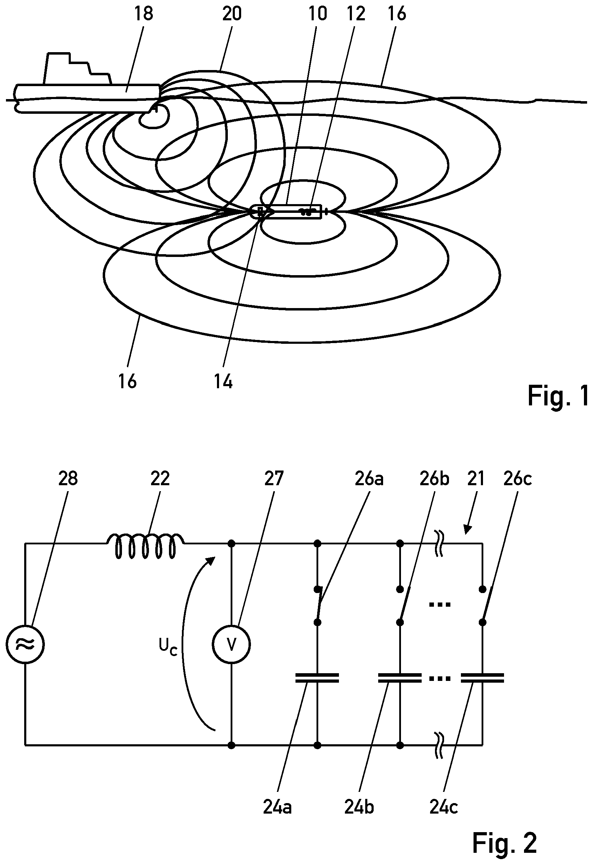

Fig. 1 zeigt ein Ausführungsbeispiel des erfindungsgemäßen Annäherungssensors, der in einem Unterwasserfahrzeug 10 angeordnet ist. Das Unterwasserfahrzeug 10, das z.B. ein Torpedo ist, weist im hinteren Bereich eine Sendeanordnung 12 und im vorderen Bereich eine Empfangsanordnung 14 auf. Die Sendeanordnung 12 ist durch eine in der Längsrichtung des Wasserfahrzeugs angeordnete Spule und die Empfangsanordnung 14 ist durch eine in Vertikal- sowie eine in Querrichtung des Unterwasserfahrzeugs 10 angeordnete dargestellt. Mit der Sendeanordnung 12 wird ein Wechselmagnetfeld 16, das hier exemplarisch durch Feldlinien dargestellt ist, ausgesendet. Das ausgesendete Wechselmagnetfeld 16 trifft auf einen elektrisch leitfähigen Körper 18, der hier als Oberflächenschiff dargestellt ist. Im elektrisch leitfähigen Körper 18, hier im Rumpf des Oberflächenschiffs, entstehen durch das ausgesendete Wechselmagnetfeld 16 Wirbelströme, die wiederum ein Wechselmagnetfeld erzeugen. Das im elektrisch leitfähigen Körper 18 erzeugte Wechselmagnetfeld 20 wird mit der Empfangsanordnung 14 des Unterwasserfahrzeugs 10 erfasst.

Fig. 2 zeigt einen Schwingkreis 21 eines Ausführungsbeispiels der Sendeanordnung 12. Der Schwingkreis 21 weist eine Spule 22, drei Kondensatoren 24a bis 24c, drei Schalter 26a bis 26c, einen Sensor 27 und eine gesteuerte Spannungsquelle 28 auf. Die gesteuerte Spannungsquelle 28, die z.B. ein getakteter Gleichspannungsschaltkreis oder eine gesteuerte Wechselspannungsquelle ist, versetzt den Schwingkreis 21 der Sendeanordnung 12 in eine elektrische Schwingung und erhält diese mit einem vordefinierten Amplitudenverlauf aufrecht. Ferner ist anstatt der Spannungsquelle 28 auch eine gesteuerte Stromquelle möglich.

Durch Schalten der Schalter 26a bis 26c ist die Frequenz der elektrischen Schwingung einstellbar. Die Schalter 26a bis 26c können dazu unabhängig voneinander in beliebiger Kombination geöffnet oder geschlossen werden. Im vorliegenden Ausführungsbeispiel der Fig. 2 ist der Schalter 26a geschlossen und sind die Schalter 26b und 26c geöffnet. Ferner sind in Fig. 2 drei Schalter 26a bis 26c und Kondensatoren 24a bis 24c dargestellt, wobei ein alternativ ausgebildeter Schwingkreis 21 mehr oder weniger als drei Schalter 26a bis 26c und Kondensatoren 24a bis 24c aufweist.

Der Sensor 27 ist hier als Spannungsmesser zum Erfassen der Spannung Uc, die über der Parallelschaltung der Kondensatoren anliegt, ausgebildet. Der Sensor 27 hat die Aufgabe die Energieverteilung im Schwingkreis 21, also den aktuellen Zustand der Schwingung, zu bestimmen. Gemäß einem weiteren Ausführungsbeispiel ist daher auch ein Sensor 27 einzusetzen, der die Feldstärke des Magnetfeldes in der Spule oder des elektrischen Feldes in dem oder den Kondensatoren bestimmt. Die Schalter 26a bis 26c werden durch nicht dargestellte Ansteuermittel angesteuert.

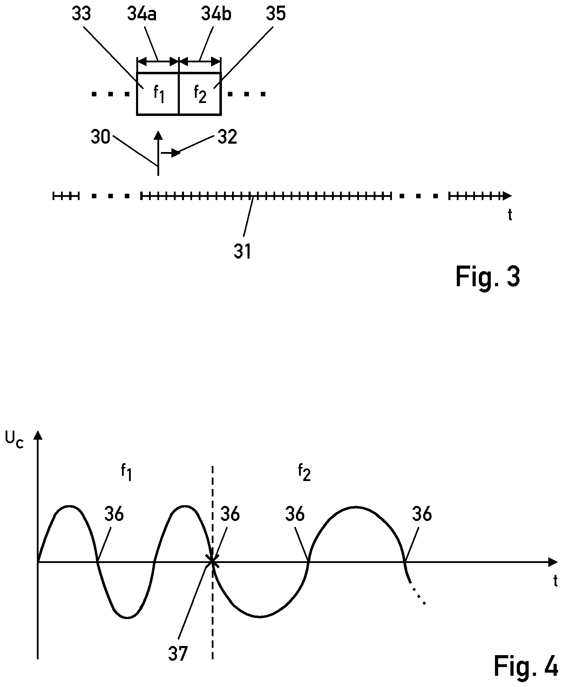

Fig. 3 zeigt einen exemplarisch dargestellten, in einer Steuerlogik, insbesondere in einer Zeitsteuerung der Steuerlogik, eines Annäherungssensors stattfindenden Ablauf der Auswahl einer Frequenz als ausgewählte Frequenz. Dazu sind die Frequenzen f1 und f2 sowie ein Zeiger 30 und eine Zeitachse 31 dargestellt. Der Zeiger 30 bewegt sich mit der Zeit, also mit dem Verlauf der Zeit, in Richtung 32 auf der Zeitachse 31 und zeigt dabei immer auf eine Frequenz. Zum dargestellten Zeitpunkt zeigt der Zeiger 30 auf die Frequenz f1, die somit zu diesem Zeitpunkt als ausgewählte Frequenz 33 ausgewählt wird. Die Frequenz f1 wird durch Fortschreiten der Zeit für ein Zeitfenster 34a, also die Dauer einer Zeitperiode, als ausgewählte Frequenz 33 ausgewählt. Nach Ablauf der Zeit des Zeitfensters 34a wird die darauffolgende Frequenz f2, die als Folgefrequenz 35 der bisherigen aktuellen ausgewählten Frequenz 34 bezeichnet wird, für ein auf das aktuelle Zeitfenster 34a folgendes Zeitfenster 34b als neue ausgewählte Frequenz 33 ausgewählt. Gemäß einem besonderen Ausführungsbeispiel ist die Dauer aller Zeitfenster 34a, 34b gleich lang. In Fig. 3 sind zeitlich direkt aufeinanderfolgende Zeitfenster 34a, 34b dargestellt, wobei die Zeitfenster 34a, 34b gemäß einem weiteren Ausführungsbeispiel zeitlich beabstandet sind.

Die Festlegung der Folgefrequenzen 35 und die Auswahl der Frequenzen als ausgewählte Frequenz 33 jeweils für ein Zeitfenster 34 erfolgt in der Steuerlogik, wobei dann mit Ansteuermitteln dieser Steuerlogik z.B. die Schalter 26a bis 26c eines Schwingkreises 21, wie er in Fig. 2 dargestellt ist, angesteuert werden. Durch derartige Ansteuerung wird ein Wechselmagnetfeld 16 mit einer Frequenz ausgesendet, wobei diese Frequenz der zu einem aktuellen Aussendezeitpunkt ausgewählten Frequenz 33 entspricht.

Fig. 4 zeigt einen Ausschnitt aus dem zeitlichen Verlauf einer Spannung Uc eines Schwingkreises 21. Der zeitliche Verlauf der Spannung Uc weist eine Frequenz auf, die einer Frequenz der elektrischen Schwingung im Schwingkreis 21 entspricht. In den Nulldurchgängen 36 des zeitlichen Verlaufs ist die gesamte Energie des Schwingkreises 21 in der Spule 22 des Schwingkreises 21 in Form eines Magnetfeldes mit einer maximalen Feldstärke bzw. Amplitude gespeichert. In diesen Nulldurchgängen 36 erfolgt daher vorzugsweise ein Umschalten der Schalter 26a bis 26c, um die Frequenz der elektrischen Schwingung des Schwingkreises 21 zu verändern. Da in diesen Nulldurchgängen 36 keine Spannung an den Kondensatoren 24a bis 24c anliegt, also keine Energie in Form eines elektrischen Feldes in den Kondensatoren 24a bis 24c gespeichert ist, entstehen auch durch Hinzuschalten oder Abtrennen der Kondensatoren 24a bis 24c mit den Schaltern 26a bis 26c in diesen Nulldurchgängen 36 keine Phasensprünge in der elektrischen Schwingung. Dies wird in Fig. 4 exemplarisch durch den Umschaltzeitpunkt 37 dargestellt, in dem die Schalter 26a bis 26c so umgeschaltet werden, dass die elektrische Schwingung, die vor dem Umschalten die Frequenz f1 aufweist, nach dem Umschalten im Umschaltzeitpunkt 37 die Frequenz f2 aufweist.

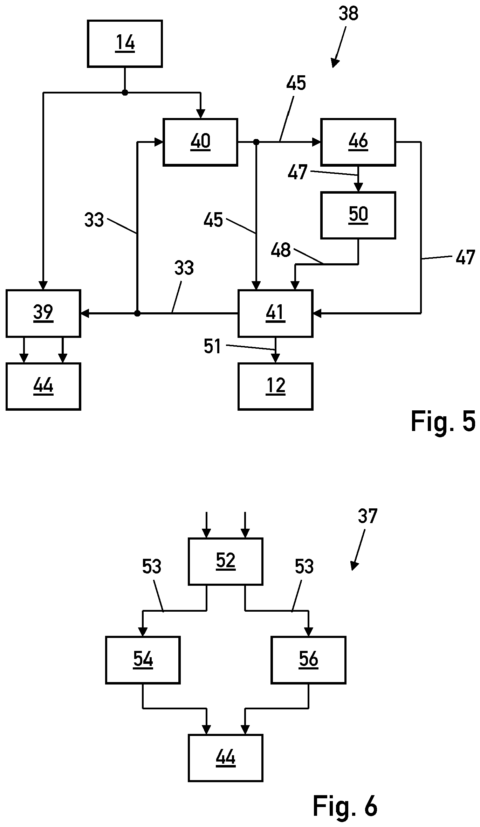

In Fig. 5 ist der schematische Aufbau eines Ausführungsbeispiels des Annäherungssensors 38 dargestellt. Der Annäherungssensor 38 weist eine Empfangsanordnung 14 auf, mit der ein Wechselmagnetfeld 20 erfasst wird. Das erfasste Wechselmagnetfeld 20 wird, z.B. nach Aufbereitung durch Umwandlung in ein elektrisches Signal, einer Auswerteschaltung 39 zugeführt. Ferner wird das elektrische Signal einem Detektionsmittel 40 zugeführt. Der Annäherungssensor 38 weist zudem eine Steuerlogik 41 auf, mit der Frequenzen als ausgewählte Frequenzen 33 ausgewählt und Folgefrequenzen 35 jeweils für jede ausgewählte Frequenz 33 festgelegt werden. Die in der Steuerlogik 41 aktuell ausgewählte Frequenz 33 wird der Auswerteschaltung 39 sowie dem Detektionsmittel 40 zugeführt.

In der Auswerteschaltung 39 werden die Amplitude und/oder die Phase der ausgewählten Frequenz 33, einer aus der ausgewählten Frequenz 33 abgeleiteten Frequenz, der Einhüllenden der ausgewählten Frequenz 33 oder der Einhüllenden der aus der ausgewählten Frequenz 33 abgeleiteten Frequenz des erfassten Wechselmagnetfeldes 20 überwacht und daraus die Annäherung bzw. ein Grad der Annäherung an den elektrisch leitfähigen Körper 18 bestimmt. Ferner ist es auch möglich z.B. anhand eines Vergleichs der Amplitude und/oder Phase der überwachten Frequenz des erfassten Wechselmagnetfeldes 20 sowie der ausgewählten Frequenz 33 des ausgesendeten Wechselmagnetfeldes 16 den Grad der Annäherung bzw. einen Wert der Annäherung zu einem elektrisch leitfähigen Körper 18 zu bestimmen. Dieser Grad bzw. die Annäherung wird dann mit einer, z.B. als Anzeige ausgebildeten, Schnittstelle 44 ausgegeben. Gemäß einem weiteren Ausführungsbeispiel ist es möglich, eine hier nicht dargestellte Auslöseeinrichtung an die Schnittstelle 44 anzuschließen, mit der ein Ereignis im Falle einer vordefinierten, z.B. der maximalen, Annäherung ausgelöst wird.

Im Detektionsmittel 40 werden anhand der ausgewählten Frequenz 33 und anhand der Frequenzen bzw. Frequenzanteile des erfassten Wechselmagnetfeldes 20 Frequenzen ermittelt bzw. detektiert, die nicht der Frequenz des ausgesendeten Wechselmagnetfeldes 16, also der ausgewählten Frequenz 33, entsprechen und jeweils eine Amplitude aufweisen, die oberhalb eines vordefinierten Schwellenwerts liegen. Diese detektierten Frequenzen 45 werden einerseits einer Speicherschaltung 46, die den zeitlichen Verlauf aller detektierten Frequenzen speichert, und andererseits einer nicht dargestellten Sperrschaltung der Steuerlogik 41 zugeführt.

Mit der Sperrschaltung der Steuerlogik 41 werden die detektierten Frequenzen 45 oder die Frequenzen eines vordefinierten Frequenzbandes jeweils mit einer der detektierten Frequenzen 45 als gesperrte Frequenzen definiert bzw. festgelegt und bei der Festlegung mindestens einer auf die ausgewählte Frequenz 33 folgenden Folgefrequenz 35 ausgeschlossen.

In der Speicherschaltung 46 werden die detektierten Frequenzen 45 gespeichert und der durch die Speicherung über einen Zeitraum erhaltene zeitliche Verlauf der detektierten Frequenzen 47 einer Prädiktionsschaltung 50 zugeführt. In der Prädiktionsschaltung 50 werden anhand des zeitlichen Verlaufs der detektierten Frequenzen 47 weitere Frequenzen 48 prädiziert. Diese weiteren Frequenzen 48 werden ebenfalls der Sperrschaltung der Steuerlogik 41, zugeführt und dort wie detektierte Frequenzen 45 behandelt, also daraus gesperrte Frequenzen festgelegt.

Ferner wird mit nicht dargestellten Ansteuermitteln der Steuerlogik 41 eine Sendeanordnung 12, insbesondere Schalter 26a bis 26c der Sendeanordnung, mit einem Steuersignal 51 derart angesteuert, sodass die Sendeanordnung 12 ein Wechselmagnetfeld mit der ausgewählten Frequenz 33 aussendet.

Fig. 6 zeigt ein vorteilhaftes Ausführungsbeispiel der Auswerteschaltung 39 mit der Schnittstelle 44. Die Auswerteschaltung 39 weist einen Mischer bzw. Frequenzmischer 52 auf. Dem Frequenzmischer 52 wird das erfasste Wechselmagnetfeld 20 bzw. ein aus dem erfassten Wechselmagnetfeld 20 abgeleitetes elektrisches Signal zugeführt. Ferner wird dem Frequenzmischer 52 die ausgewählte Frequenz 33 bzw. ein aus der ausgewählten Frequenz 33 abgeleitetes elektrisches Signal zugeführt. Im Frequenzmischer 52 werden die beiden Signale multiplikativ gemischt. Das Ergebnis der Mischung ist ein gemischtes Signal 53, das einerseits einer Amplitudenüberwachungsschaltung 54 und andererseits einer Phasenüberwachungsschaltung 56 zugeführt wird.

In der Amplitudenüberwachungsschaltung 54 und in der Phasenüberwachungsschaltung 56 wird das gemischte Signal 53 jeweils mit einem Bandpassfilter gefiltert. In der Amplitudenüberwachungsschaltung 54 wird z.B. ein Bandpassfilter gewählt, das schmalbandig ist, damit bei der Überwachung der Amplituden nur die Frequenz betracht wird, die der im Zeitfenster der Überwachung ausgewählten Frequenz 33 nach der Mischung entspricht. In der Phasenüberwachungsschaltung 56 wird das Bandpassfilter hingegen im Vergleich zur Amplitudenüberwachungsschaltung 54 z.B. breiter gewählt, damit auch Phasen der Frequenzen betrachtet werden, die in einem vordefinierten Frequenzband weiter "oberhalb" oder "unterhalb" der Frequenz liegen, die der im Zeitfenster der Überwachung ausgewählten Frequenz nach der Mischung entspricht.

In der Amplitudenüberwachungsschaltung 54 wird die Amplitude dieser gemischten Frequenz oder die Einhüllende dieser Frequenz überwacht und z.B. bei Erreichen eines bestimmten Wertes der Amplitude und/oder bei Erreichen des Maximums der Amplitude z.B. ein Auslöseimpuls an der Schnittstelle 44 ausgegeben. In der Phasenüberwachungsschaltung 46 wird die Phase der gemischten Frequenz oder die Einhüllende dieser Frequenz überwacht und im Falle einer Phase, die sich zeitlich schneller ändert, als es durch einen vordefinierten weiteren Schwellenwert vorgeben ist, wird ebenfalls ein Signal an der Schnittstelle 44 ausgegeben, sodass eine mit der Schnittstelle verbundene Auslöseeinrichtung (nicht dargestellt) einen auftretenden Auslöseimpuls im Falle eines im gleichen Zeitbereich auftretenden Signals der Phasenüberwachungsschaltung 46 ignorieren kann.

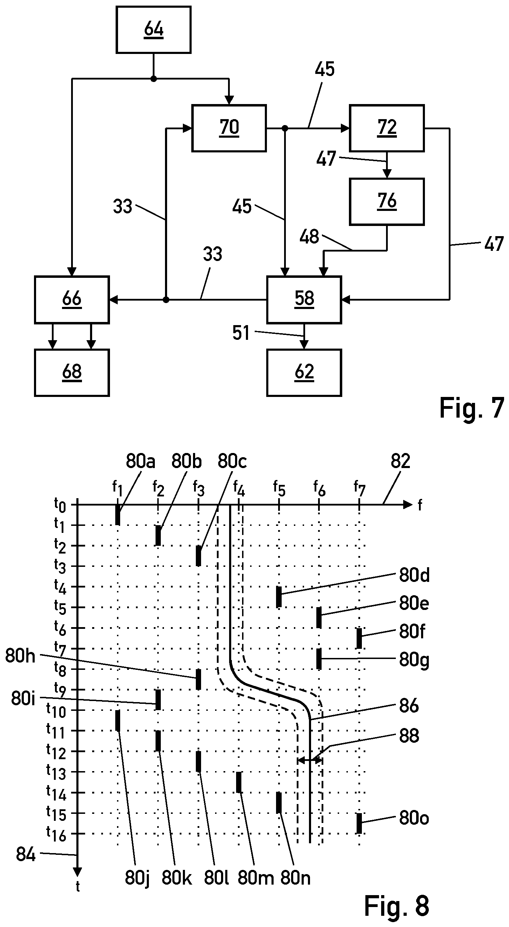

Fig. 7 zeigt analog zur Fig. 5 einen Ablaufplan eines Ausführungsbeispiels des erfindungsgemäßen Verfahrens. In einem Steuerschritt 58 werden Frequenzen ausgewählt und Folgefrequenzen 35 für die jeweilige ausgewählte Frequenz 33 ermittelt. In einem Sendeschritt 62 wird dann ein Wechselmagnetfeld 16 mit der jeweils ausgewählten Frequenz 33 ausgesendet. In einem Empfangsschritt 64 werden Wechselmagnetfelder 20 erfasst und in einem Auswerteschritt 66 die Annäherung durch Auswerten des ausgesendeten Wechselmagnetfeldes 16, insbesondere durch Vergleichen mit dem erfassten Wechselmagnetfeld 20, bestimmt.

Ferner werden in einem Detektionsschritt 70 eine oder mehrere Frequenzen des erfassten Wechselmagnetfeldes 20, im Falle dass diese außerhalb eines vordefinierten bzw. vorbestimmten Frequenzbandes, das die ausgewählte Frequenz 33 einschließt, liegen und einen Amplitudenwert oberhalb eines vordefinierten Schwellenwerts aufweisen, detektiert. "Vorbestimmt" bzw. "vordefiniert" bedeutet hier, dass zumindest die Bandbreite und die Position der ausgewählten Frequenz 33 innerhalb des Frequenzbandes, also der Abstand und die Richtung der ausgewählten Frequenz zur Mittenfrequenz des jeweiligen Frequenzbandes, im Voraus festgelegt sind.

In einem Sperrschritt des Steuerschritts 58 werden jeweils für einen Zeitraum Frequenzen eines die detektierte Frequenz 45 aufweisenden vordefinierten Frequenzbandes oder mehrerer jeweils mindestens eine der detektierten Frequenzen 45 aufweisender vorbestimmter Frequenzbänder als gesperrte Frequenzen definiert. Diese gesperrten Frequenzen werden dann in der Steuerlogik 41 für Zeitpunkte des Zeitraums, die innerhalb der vordefinierten Zeitdauer liegen, nicht als Folgefrequenzen 35 festgelegt.

Fig. 8 zeigt einen zeitlichen Verlauf der Frequenz des mit einem Ausführungsbeispiel der Erfindung ausgesendeten Wechselmagnetfeldes 16. Dieser zeitliche Verlauf ist durch die Linien 80a bis 80o dargestellt. Jede der Linien 80a bis 80o entspricht jeweils einer der auf einer Frequenzachse 82 abzulesenden Frequenzen f1 bis f7. Jede Linie 80a bis 80o ist zusätzlich einem vordefinierten Zeitfenster 34 zugeordnet, dessen Zeitpunkte auf einer Zeitachse 84 abzulesen sind. Jedes Zeitfenster 34 umfasst hier die gleiche Dauer. Jede Linie 80a bis 80o entspricht also einer der Frequenzen f1 bis f7, die in einem auf der Frequenzachse ablesbaren Zeitfenster 34 als ausgewählte Frequenz 33 ausgewählt wurde. Es wurde also z.B. vom Zeitpunkt t0 bis t1 ein Wechselmagnetfeld 16 mit der Frequenz f1 ausgesendet, vom Zeitpunkt t1 bis zum Zeitpunkt t2 wurde ein Wechselmagnetfeld mit der Frequenz f2 ausgesendet, usw. Die Frequenz f2 im Zeitfenster t1 bis t2 entspricht der Folgefrequenz 35 der davor ausgewählten Frequenz f1 im davor aktuellen Zeitfenster t0 bis t1.

Ferner ist die Frequenz 86 eines störenden Magnetfeldes dargestellt. Diese Variiert über den zeitlichen Verlauf, etwa im Zeitfenster von t8 bis t10. Um die Frequenz 86 des störenden Magnetfeldes ist ein Frequenzband 88 dargestellt.

Betrachtet man den zeitlichen Verlauf der Frequenzen f1 bis f7, so ist erkennbar, dass diese niemals im Bereich des Frequenzbandes 88 liegen. Ursache hierfür ist, dass in der Steuerlogik 41 bzw. im Steuerschritt 58 ausschließlich Frequenzen für die sequentiell aufeinanderfolgenden Frequenzen festgelegt werden, die nicht vom Detektionsmittel 40 bzw. im Detektionsschritt 70 detektiert und mit der Sperrschaltung bzw. im Sperrschritt von der Festlegung ausgeschlossen bzw. als gesperrte Frequenzen definiert wurden.

Somit ermöglicht der erfindungsgemäße Annäherungssensor 36 und das erfindungsgemäße Verfahren zum Bestimmen der Annäherung an einen elektrisch leitfähigen Körper 18 eine zuverlässige Annäherungsbestimmung, die unabhängig von störenden Wechselmagnetfeldern ist.

Sämtliche in der vorstehenden Beschreibung sowie in den Ansprüchen genannten Merkmale sind sowohl einzeln als auch in beliebiger Kombination miteinander einsetzbar. Der Rahmen der Erfindung ist in den Ansprüchen definiert.

## Patentansprüche

1. Annäherungssensor (36) zur Bestimmung der Annäherung an einen elektrisch leitfähigen Körper (18) mit folgenden Merkmalen:
a) einer Sendeanordnung (12) zum Aussenden eines Wechselmagnetfeldes (16) mit einer ausgewählten Frequenz (33, 80a-80n), um Wirbelströme in einem leitfähigen Körper zu erzeugen,
b) einer Empfangsanordnung (14) zum Erfassen eines, unter Anderem, durch die Wirbelströme erzeugten Wechselmagnetfeldes (20),
c) einem Detektionsmittel (40) zum Detektieren einer oder mehrerer Frequenzen des erfassten Wechselmagnetfeldes (20), die außerhalb eines die ausgewählte Frequenz (33, 80a-80n) aufweisenden vordefinierten Frequenzbandes liegen und einen Amplitudenwert oberhalb eines vordefinierten Schwellenwerts aufweisen und mit
d) einer Steuerlogik (41) mit:
i) einer Sperrschaltung zum Festlegen von Frequenzen eines die von dem Detektionsmittel (40) detektierte Frequenz (45) aufweisenden vordefinierten weiteren Frequenzbandes oder mehrerer jeweils mindestens eine der von dem Detektionsmittel (40) detektierten Frequenzen aufweisender vordefinierter weiterer Frequenzbänder als für eine vordefinierte Zeitdauer gesperrte Frequenzen,
ii) einer Auswahlsteuerung zum Festlegen einer auf die jeweilige ausgewählte Frequenz (33, 80a-80n) folgenden, sich von der jeweiligen ausgewählten und von den gesperrten Frequenzen unterscheidenden Folgefrequenz (35, 80a-80n) der jeweiligen ausgewählten Frequenz (33) und
iii) einer Zeitsteuerung zur fortlaufenden Auswahl der jeweiligen Folgefrequenz einer aktuell ausgewählten Frequenz (33, 80a-80n) als neue ausgewählte Frequenz (33, 80a-80n) zeitlich direkt nach oder zeitlich beabstandet nach einem für die aktuell ausgewählte Frequenz (33, 80a-80n) vorbestimmten Zeitfenster (34).

2. Annäherungssensor (36) nach Anspruch 1,
**dadurch gekennzeichnet, dass**
die Sendeanordnung (12) einen Schwingkreis (21) mit mindestens einer Spule (22) und mehreren jeweils durch Schalter (26) in beliebiger Kombination zueinander parallel schaltbaren Kondensatoren (24) zum Erzeugen einer elektrischen Schwingung mit der ausgewählten Frequenz (33, 80a-80n) und eines aus der Schwingung resultierenden Wechselmagnetfeldes (16) und die Steuerlogik (41) Ansteuermittel zum Ansteuern der Schalter (26) des Schwingkreises (21) zum Umschalten der Frequenz der elektrischen Schwingung aufweist.

3. Annäherungssensor (36) nach Anspruch 2,
**dadurch gekennzeichnet, dass**
der Schwingkreis (21) einen Sensor (27) zum Messen der Energieverteilung im Schwingkreis (21) aufweist und die Ansteuermittel derart ausgebildet sind, um die Schalter (26) des Schwingkreises (21) nur im Maximum oder im Bereich des Maximums der gemessenen Energie in der Spule (22) umzuschalten.

4. Annäherungssensor (36) nach einem der vorhergehenden Ansprüche,
**dadurch gekennzeichnet, dass**
der Annäherungssensor (36) eine Auswerteschaltung (39) mit einer Amplitudenüberwachungsschaltung (54) zur Annäherungsbestimmung durch Überwachen der Amplitude der ausgewählten Frequenz (33, 80a-80n), einer aus der ausgewählten Frequenz (33, 80a-80n) abgeleiteten Frequenz, der Einhüllenden der ausgewählten Frequenz (33, 80a-80n) oder der Einhüllenden der aus der ausgewählten Frequenz (33, 80a-80n) abgeleiteten Frequenz des erfassten Wechselmagnetfeldes (20) aufweist.

5. Annäherungssensor (36) nach Anspruch 4,
**dadurch gekennzeichnet, dass**
der Annäherungssensor (36) eine Auswerteschaltung (39) mit einer Phasenüberwachungsschaltung (56) zum Überwachen der Phase der ausgewählten Frequenz (33, 80a-80n), einer aus der ausgewählten Frequenz (33, 80a-80n) abgeleiteten Frequenz, der Einhüllenden der ausgewählten Frequenz (33, 80a-80n) oder der Einhüllenden der aus der ausgewählten Frequenz (33, 80a-80n) abgeleiteten Frequenz des erfassten Wechselmagnetfeldes (20) und zum Validieren der Ergebnisse bei der Annäherungsbestimmung aufweist.

6. Annäherungssensor (36) nach einem der vorhergehenden Ansprüche,
**dadurch gekennzeichnet, dass**
die Auswerteschaltung (39) einen Frequenzmischer (52) zum Mischen eines aus dem erfassten Wechselmagnetfeld (20) und eines aus der ausgewählten Frequenz (33, 80a-80n) abgeleiteten elektrischen Signals aufweist.

7. Annäherungssensor (36) nach einem der vorhergehenden Ansprüche,
**dadurch gekennzeichnet, dass**
der Annäherungssensor (36) eine Speicherschaltung (46) zum Speichern des zeitlichen Verlaufs detektierter Frequenzen (47) und eine Prädiktionsschaltung (50) zum Prädizieren weiterer Frequenzen aus dem zeitlichen Verlauf bereits detektierter Frequenzen (48) und zum Übergeben der weiteren Frequenzen (48) als detektierte Frequenzen (45) an die Sperrschaltung aufweist.

8. Annäherungssensor (36) nach einem der vorhergehenden Ansprüche,
**dadurch gekennzeichnet, dass**
die Steuerlogik (41) eine Korrekturschaltung zum Korrigieren der Ergebnisse der Annäherungsbestimmung mit Kenntnis der detektierten Frequenzen (45) aufweist.

9. Verfahren zur Bestimmung der Annäherung an einen elektrisch leitfähigen Körper (18) wobei das Verfahren die folgenden Schritte umfasst:
a) einen Sendeschritt (62), bei dem ein Wechselmagnetfeld (16) mit einer ausgewählten Frequenz (33, 80a-80n) ausgesendet wird, um Wirbelströme in dem elektrisch leitfähigen Körper zu erzeugen,
b) einen Empfangsschritt (64), bei dem ein, unter Andererm, durch die Wirbelströme erzeugtes Wechselmagnetfeld (20) erfasst wird,
c) einen Detektionsschritt (70), bei dem eine oder mehrere Frequenzen des erfassten Wechselmagnetfeldes (20), die außerhalb eines die ausgewählte Frequenz (33, 80a-80n) aufweisenden vordefinierten Frequenzbandes liegen und einen Amplitudenwert oberhalb eines vordefinierten Schwellenwerts aufweisen, detektiert werden und durch die folgenden Schritte gekennzeichnet:
d) einen Steuerschritt (58) mit:
i) einem Sperrschritt, bei dem Frequenzen eines die detektierte Frequenz (45, 86) aufweisenden vordefinierten weiteren Frequenzbandes (88) oder mehrerer jeweils mindestens eine der detektierten Frequenzen (45, 86) aufweisender vordefinierter weiterer Frequenzbänder (88) für eine vordefinierte Zeitdauer als gesperrte Frequenzen festgelegt werden,
ii) einem Auswahlschritt, bei dem eine auf die jeweilige ausgewählte Frequenz (33, 80a-80n) folgende, sich von der jeweiligen ausgewählten und von den gesperrten Frequenzen unterscheidende Folgefrequenz (35) der jeweiligen ausgewählten Frequenz (33, 80a-80n), ausgewählt wird und
iii) einem Zeitsteuerschritt, bei dem fortlaufend die jeweilige Folgefrequenz einer aktuell ausgewählten Frequenz (33, 80a-80n) als neue ausgewählte Frequenz (33, 80a-80n) zeitlich direkt nach oder zeitlich beabstandet nach einem für die aktuell ausgewählte Frequenz (33, 80a-80n) vorbestimmten Zeitfenster (34) ausgewählt wird.

10. Verfahren nach Anspruch 9,
**dadurch gekennzeichnet, dass**
im Sendeschritt (62) mit einen Schwingkreis (21) mit mindestens einer Spule (22) und mehreren jeweils durch Schalter (26) in beliebiger Kombination zueinander parallel schaltbaren Kondensatoren (24) eine elektrische Schwingung mit der ausgewählten Frequenz (33, 80a-80n) und ein aus der Schwingung resultierendes Wechselmagnetfeld (16) erzeugt werden und in einem Ansteuerschritt des Steuerschritts (58) die Schalter (26) des Schwingkreises (21) zum Umschalten der Frequenz der elektrischen Schwingung umgeschaltet werden.

11. Verfahren nach Anspruch 10,
**dadurch gekennzeichnet, dass**
im Sendeschritt (62) die Energieverteilung im Schwingkreis (21) mit mindestens einem Sensor (27) erfasst wird und im Ansteuerschritt die Schalter (26) des Schwingkreises (21) im Maximum oder im Bereich des Maximums der gemessenen Energie in der Spule (22) umgeschaltet werden.

12. Verfahren nach einem der vorhergehenden Ansprüche 9 bis 11,
**dadurch gekennzeichnet, dass**
in einem Auswerteschritt (39) mit einer Amplitudenüberwachungsschaltung (54) die Annäherung durch Überwachen der Amplitude der ausgewählten Frequenz (33, 80a-80n), einer aus der ausgewählten Frequenz (33, 80a-80n) abgeleiteten Frequenz, der Einhüllenden der ausgewählten Frequenz (33) oder der Einhüllenden der aus der ausgewählten Frequenz (33, 80a-80n) abgeleiteten Frequenz des erfassten Wechselmagnetfeldes (20) bestimmt wird.

13. Verfahren nach Anspruch 12,
**dadurch gekennzeichnet, dass**
in einem Auswerteschritt (39) des Verfahren mit einer Phasenüberwachungsschaltung (56) die Phase der ausgewählten Frequenz (33, 80a-80n), einer aus der ausgewählten Frequenz (33, 80a-80n) abgeleiteten Frequenz, der Einhüllenden der ausgewählten Frequenz (33, 80a-80n) oder der Einhüllenden der aus der ausgewählten Frequenz (33, 80a-80n) abgeleiteten Frequenz des erfassten Wechselmagnetfeldes (20) überwacht und die Ergebnisse bei der Annäherungsbestimmung validiert werden.

## Claims

1. Proximity sensor (36) for determining the proximity to an electrically conductive body (18) having the following features:
a) a transmission arrangement (12) for transmitting an alternating magnetic field (16) at a selected frequency (33, 80a-80n) in order to generate eddy currents in a conductive body,
b) a reception arrangement (14) for detecting an alternating magnetic field (20) generated inter alia by the eddy currents,
c) a detection means (40) for detecting one or more frequencies of the detected alternating magnetic field (20), said frequencies lying outside of a predefined frequency range having the selected frequency (33, 80a-80n) and having an amplitude value above a predefined threshold value and
having
d) a control logic (41) having:
i) a blocking circuit for determining frequencies of a predefined further frequency range having the frequency (45) detected by the detection means (40) or a plurality of predefined further frequency ranges having in each case at least one of the frequencies detected by the detection means (40) as frequencies blocked for a predefined period,
ii) a selection controller for determining a repetition frequency (35, 80a-80n) of the respective selected frequency (33), said repetition frequency following the respective selected frequency (33, 80a-80n) and differing from the respective selected and from the blocked frequencies, and
iii) a time controller for the continual selection of the respective repetition frequency of a presently selected frequency (33, 80a-80n) as the new selected frequency (33, 80a-80n) temporally directly after or temporally delayed after a time window (34) predetermined for the presently selected frequency (33, 80a-80n).

2. Proximity sensor (36) according to Claim 1,
**characterized in that**
the transmission arrangement (12) has a resonant circuit (21) having at least one coil (22) and a plurality of capacitors (24) able to be connected in parallel with one another in each case by switches (26) in any combination in order to generate an electrical oscillation at the selected frequency (33, 80a-80n) and an alternating magnetic field (16) resulting from the oscillation and the control logic (41) has actuation means for actuating the switches (26) of the resonant circuit (21) in order to switch over the frequency of the electrical oscillation.

3. Proximity sensor (36) according to Claim 2,
**characterized in that**
the resonant circuit (21) has a sensor (27) for measuring the energy distribution in the resonant circuit (21) and the actuation means are designed in such a way as to switch over the switches (26) of the resonant circuit (21) only at the maximum or in the range of the maximum of the measured energy in the coil (22).

4. Proximity sensor (36) according to one of the preceding claims,
**characterized in that**
the proximity sensor (36) has an evaluation circuit (39) having an amplitude monitoring circuit (54) for determining the proximity by monitoring the amplitude of the selected frequency (33, 80a-80n), a frequency derived from the selected frequency (33, 80a-80n), the envelopes of the selected frequency (33, 80a-80n) or the envelopes of the frequency of the detected alternating magnetic field (20) derived from the selected frequency (33, 80a-80n) .

5. Proximity sensor (36) according to Claim 4,
**characterized in that**
the proximity sensor (36) has an evaluation circuit (39) having a phase monitoring circuit (56) for monitoring the phase of the selected frequency (33, 80a-80n), a frequency derived from the selected frequency (33, 80a-80n), the envelopes of the selected frequency (33, 80a-80n) or the envelopes of the frequency of the detected alternating magnetic field (20) derived from the selected frequency (33, 80a-80n) and for validating the results during the proximity determination.

6. Proximity sensor (36) according to one of the preceding claims,
**characterized in that**
the evaluation circuit (39) has a frequency mixer (52) for mixing an electrical signal derived from the detected alternating magnetic field (20) and an electrical signal derived from the selected frequency (33, 80a-80n).

7. Proximity sensor (36) according to one of the preceding claims,
**characterized in that**
the proximity sensor (36) comprising a memory circuit (46) for storing the time profile of detected frequencies (47) and a prediction circuit (50) for predicting further frequencies from the time profile of frequencies (48) that have already been detected and for transmitting the further frequencies (48) as detected frequencies (45) to the blocking circuit.

8. Proximity sensor (36) according to one of the preceding claims,
**characterized in that**
the control logic (41) has a correction circuit for correcting the results of the proximity determination with knowledge of the detected frequencies (45).

9. Method for determining the proximity to an electrically conductive body (18), wherein the method comprises the following steps:
a) a transmission step (62), in which an alternating magnetic field (16) is transmitted at a selected frequency (33, 80a-80n) in order to generate eddy currents in the electrically conductive body,
b) a reception step (64), in which an alternating magnetic field (20) generated inter alia by the eddy currents is detected,
c) a detection step (70), in which one or more frequencies of the detected alternating magnetic field (20), said frequencies lying outside of a predefined frequency range having the selected frequency (33, 80a-80n) and having an amplitude value above a predefined threshold value, are detected and
**characterized by** the following steps:
d) a control step (58) having:
i) a blocking step, in which frequencies of a predefined further frequency range (88) having the detected frequency (45, 86) or a plurality of predefined further frequency ranges (88) having in each case at least one of the detected frequencies are determined as frequencies blocked for a predefined period,
ii) a selection step, in which a repetition frequency (35) of the respective selected frequency (33, 80a-80n), said repetition frequency following the respective selected frequency (33, 80a-80n) and differing from the respective selected and from the blocked frequencies, is selected, and
iii) a time control step, in which the respective repetition frequency of a presently selected frequency (33, 80a-80n) is continually selected as the new selected frequency (33, 80a-80n) temporally directly after or temporally delayed after a time window (34) predetermined for the presently selected frequency (33, 80a-80n).

10. Method according to Claim 9,
**characterized in that**,
in the transmission step (62), an electrical oscillation at the selected frequency (33, 80a-80n) and an alternating magnetic field (16) resulting from the oscillation are generated by way of a resonant circuit (21) having at least one coil (22) and a plurality of capacitors (24) able to be connected in parallel with one another in each case by switches (26) in any combination and, in an actuation step of the control step (58), the switches (26) of the resonant circuit (21) are switched over in order to switch over the frequency of the electrical oscillation.

11. Method according to Claim 10,
**characterized in that**,
in the transmission step (62), the energy distribution in the resonant circuit (21) is detected by way of at least one sensor (27) and, in the actuation step, the switches (26) of the resonant circuit (21) are switched over at the maximum or in the range of the maximum of the measured energy in the coil (22).

12. Method according to one of the preceding Claims 9 to 11,
**characterized in that**,
in an evaluation step (39), the proximity is determined by way of an amplitude monitoring circuit (54) by monitoring the amplitude of the selected frequency (33, 80a-80n), a frequency derived from the selected frequency (33, 80a-80n), the envelopes of the selected frequency (33) or the envelopes of the frequency of the detected alternating magnetic field (20) derived from the selected frequency (33, 80a-80n).

13. Method according to Claim 12,
**characterized in that**,
in an evaluation step (39) of the method, the phase of the selected frequency (33, 80a-80n), a frequency derived from the selected frequency (33, 80a-80n), the envelopes of the selected frequency (33, 80a-80n) or the envelopes of the frequency of the detected alternating magnetic field (20) derived from the selected frequency (33, 80a-80n) is monitored using a phase monitoring circuit (56) and the results are validated during the proximity determination.

## Revendications

1. Détecteur d'approche (36) destiné à déterminer l'approche vers un corps électriquement conducteur (18), possédant les caractéristiques suivantes :
a) un arrangement d'émission (12) destiné à émettre un champ magnétique alternatif (16) ayant une fréquence choisie (33, 80a-80n) en vue de générer des courants de Foucault dans un corps conducteur,
b) un arrangement de réception (14) destiné à détecter un champ magnétique alternatif (20) généré, entre autres, par les courants de Foucault,
c) un moyen de détection (40) destiné à détecter une ou plusieurs fréquences du champ magnétique alternatif (20) détecté, lesquelles se trouvent en-dehors d'une bande de fréquences prédéfinie qui présente la fréquence choisie (33, 80a-80n) et possèdent une valeur d'amplitude supérieure à une valeur de seuil prédéfinie, et comprenant
d) une logique de commande (41) comprenant :
i) un circuit de blocage destiné à fixer des fréquences d'une bande de fréquences supplémentaire prédéfinie qui présente la fréquence (45) détectée par le moyen de détection (40) ou de plusieurs bandes de fréquences supplémentaires prédéfinies qui présentent respectivement au moins l'une des fréquences détectées par le moyen de détection (40) en tant que fréquences bloquées pendant une durée prédéfinie,
ii) une commande de sélection destinée à fixer une fréquence de répétition (35, 80a-80n) de la fréquence choisie (33) respective, qui suit la fréquence choisie (35, 80a-80n) respective et qui est différente des fréquences respectivement choisies et bloquées et
iii) une commande temporelle destinée à sélectionner continuellement la fréquence de répétition respective d'une fréquence choisie (33, 80a-80n) actuelle en tant que nouvelle fréquence choisie (33, 80a-80n) chronologiquement directement après ou chronologiquement espacée après une fenêtre temporelle (34) prédéfinie pour la fréquence choisie (33, 80a-80n) actuelle.

2. Détecteur d'approche (36) selon la revendication 1, **caractérisé en ce que** l'arrangement d'émission (12) possède un circuit oscillant (21) comprenant au moins une bobine (22) et plusieurs condensateurs (24) pouvant être branchés en parallèle les uns avec les autres dans une combinaison quelconque par des commutateurs (26) en vue de générer une oscillation électrique ayant la fréquence choisie (33, 80a-80n) et un champ magnétique alternatif (16) résultant de l'oscillation, et la logique de commande (41) des moyens d'attaque destinés à attaquer les commutateurs (26) du circuit oscillant (21) en vue de permuter la fréquence de l'oscillation électrique.

3. Détecteur d'approche (36) selon la revendication 2, **caractérisé en ce que** le circuit oscillant (21) possède un capteur (27) destiné à mesurer la distribution d'énergie dans le circuit oscillant (21) et les moyens d'attaque sont configurés de manière à permuter les commutateurs (26) du circuit oscillant (21) seulement au maximum ou dans la plage du maximum de l'énergie mesurée dans la bobine (22).

4. Détecteur d'approche (36) selon l'une des revendications précédentes, **caractérisé en ce que** le détecteur d'approche (36) possède un circuit d'interprétation (39) comprenant un circuit de surveillance d'amplitude (54) servant à la détermination de l'approche par surveillance de l'amplitude de la fréquence choisie (33, 80a-80n), d'une fréquence dérivée de la fréquence choisie (33, 80a-80n), de l'enveloppante de la fréquence choisie (33, 80a-80n) ou de l'enveloppante de la fréquence dérivée de la fréquence choisie (33, 80a-80n) du champ magnétique alternatif (20) détecté.

5. Détecteur d'approche (36) selon la revendication 4, **caractérisé en ce que** le détecteur d'approche (36) possède un circuit d'interprétation (39) comprenant un circuit de surveillance de phase (56) servant à surveiller la phase de la fréquence choisie (33, 80a-80n), une fréquence dérivée de la fréquence choisie (33, 80a-80n), l'enveloppante de la fréquence choisie (33, 80a-80n) ou l'enveloppante de la fréquence dérivée de la fréquence choisie (33, 80a-80n) du champ magnétique alternatif (20) détecté et à valider les résultats lors de la détermination de l'approche.

6. Détecteur d'approche (36) selon l'une des revendications précédentes, **caractérisé en ce que** le circuit d'interprétation (39) possède un mélangeur de fréquence (52) destiné à mélanger un signal électrique dérivé du champ magnétique alternatif (20) détecté et un signal électrique dérivé de la fréquence choisie (33, 80a-80n) .

7. Détecteur d'approche (36) selon l'une des revendications précédentes, **caractérisé en ce que** le détecteur d'approche (36) comprenant un circuit de mémorisation (46) destiné à mémoriser le tracé dans le temps des fréquences (47) détectées et un circuit de prédiction (50) destiné à prédire des fréquences supplémentaires à partir du tracé dans le temps des fréquences (48) déjà détectées et à transmettre les fréquences supplémentaires (48) sous la forme de fréquences détectées (45) au circuit de blocage.

8. Détecteur d'approche (36) selon l'une des revendications précédentes, **caractérisé en ce que** la logique de commande (41) possède un circuit de correction destiné à corriger les résultats de la détermination de l'approche avec la connaissance des fréquences détectées (45) .

9. Procédé de détermination de l'approche vers un corps électriquement conducteur (18), le procédé comprenant les étapes suivantes :
a) une étape d'émission (62), lors de laquelle un champ magnétique alternatif (16) ayant une fréquence choisie (33, 80a-80n) est émis en vue de générer des courants de Foucault dans le corps électriquement conducteur,
b) une étape de réception (64), lors de laquelle un champ magnétique alternatif (20) généré, entre autres, par les courants de Foucault est détecté,
c) une étape de détection (70) lors de laquelle une ou plusieurs fréquences du champ magnétique alternatif (20) détecté, lesquelles se trouvent en-dehors d'une bande de fréquences prédéfinie qui présente la fréquence choisie (33, 80a-80n) et possèdent une valeur d'amplitude supérieure à une valeur de seuil prédéfinie, sont détectées et
**caractérisé par** les étapes suivantes :
d) une étape de commande (58) comprenant :
i) une étape de blocage, lors de laquelle des fréquences d'une bande de fréquences supplémentaire prédéfinie (88) qui présente la fréquence (45, 86) ou de plusieurs bandes de fréquences supplémentaires prédéfinies (88) qui présentent respectivement au moins l'une des fréquences détectées (45, 86) sont fixées en tant que fréquences bloquées pendant une durée prédéfinie,
ii) une étape de sélection, lors de laquelle une fréquence de répétition (35) de la fréquence choisie (33, 80a-80n) respective, qui suit la fréquence choisie (33, 80a-80n) respective et qui est différente des fréquences respectivement choisies et bloquées, est sélectionnée et
iii) une étape de commande temporelle, lors de laquelle la fréquence de répétition respective d'une fréquence choisie (33, 80a-80n) actuelle est continuellement sélectionnée en tant que nouvelle fréquence choisie (33, 80a-80n) chronologiquement directement après ou chronologiquement espacée après une fenêtre temporelle (34) prédéfinie pour la fréquence choisie (33, 80a-80n) actuelle.

10. Procédé selon la revendication 9, **caractérisé en ce que** dans l'étape d'émission (62), une oscillation électrique ayant la fréquence choisie (33, 80a-80n) et un champ magnétique alternatif (16) résultant de l'oscillation sont générés avec un circuit oscillant (21) comprenant au moins une bobine (22) et plusieurs condensateurs (24) pouvant être branchés en parallèle les uns avec les autres dans une combinaison quelconque par des commutateurs (26), et dans une étape d'attaque de l'étape de commande (58), les commutateurs (26) du circuit oscillant (21) sont permutés en vue de permuter la fréquence de l'oscillation électrique.

11. Procédé selon la revendication 10, **caractérisé en ce que** dans l'étape d'émission (62), la distribution d'énergie dans le circuit oscillant (21) est détectée avec au moins un capteur (27), et dans l'étape d'attaque, les commutateurs (26) du circuit oscillant (21) sont permutés au maximum ou dans la plage du maximum de l'énergie mesurée dans la bobine (22).

12. Procédé selon l'une des revendications précédentes 9 à 11, **caractérisé en ce que** dans l'étape d'interprétation (39), l'approche est déterminée avec un circuit de surveillance d'amplitude (54) par surveillance de l'amplitude de la fréquence choisie (33, 80a-80n), d'une fréquence dérivée de la fréquence choisie (33, 80a-80n), de l'enveloppante de la fréquence choisie (33) ou de l'enveloppante de la fréquence dérivée de la fréquence choisie (33, 80a-80n) du champ magnétique alternatif (20) détecté.

13. Procédé selon la revendication 12, **caractérisé en ce que** dans l'étape d'interprétation (39), le procédé surveille la phase de la fréquence choisie (33, 80a-80n), une fréquence dérivée de la fréquence choisie (33, 80a-80n), l'enveloppante de la fréquence choisie (33, 80a-80n) ou l'enveloppante de la fréquence dérivée de la fréquence choisie (33, 80a-80n) du champ magnétique alternatif (20) détecté avec un circuit de surveillance de phase (56) et les résultats sont validés lors de la détermination de l'approche.
